# EUROPEAN PATENT SPECIFICATION

(11) **EP 3 350 891 B1**
(45) Date of publication and mention of the grant of the patent: **28.10.2020**
(21) Application number: 16845933.7
(22) Date of filing: 12.09.2016
(51) Int. Cl.: H01S 5/042, H01S 5/227, H01S 5/34, H01S 5/343

(54) **SEMICONDUCTOR LASER**
HALBLEITERLASER
LASER À SEMI-CONDUCTEURS

(30) Priority: 14.09.2015 JP 2015180925; 09.08.2016 JP 2016156514
(43) Date of publication of application: 25.07.2018
(73) Proprietor: Sumitomo Electric Industries, Ltd., Osaka-shi, Osaka 541-0041 (JP)
(72) Inventor: KATSUYAMA, Tsukuru, Yokohama-shi Kanagawa 244-8588 (JP); KATO, Takashi, Yokohama-shi Kanagawa 244-8588 (JP)
(74) Representative: Grünecker Patent- und Rechtsanwälte PartG mbB
(86) International application number: PCT/JP2016/004125
(87) International publication number: WO 2017/047059

(56) References cited:
- EP-A1- 1 708 318
- WO-A1-95/15022
- JP-A- 2012 151 291
- JP-A- 2013 149 665
- JP-A- 2013 165 152
- US-A- 5 739 543
- US-A1- 2006 065 886
- US-A1- 2013 182 736
- MITIN V ET AL: "Population inversion and terahertz lasing in graphene", MICRO- AND NANOTECHNOLOGY SENSORS, SYSTEMS, AND APPLICATIONS IV, SPIE, 1000 20TH ST. BELLINGHAM WA 98225-6705 USA, vol. 8373, no. 1, 11 May 2012 (2012-05-11) , pages 1-14, XP060002804, DOI: 10.1117/12.918662 [retrieved on 2012-05-21]

## Description

### [Technical Field]

The present invention relates to a semiconductor laser that has a radiation mechanism using unipolar carriers.

### [Background Art]

A Japanese Patent Document laid open No H08-279647A has disclosed a quantum cascade laser using radiative transitions between energy levels by unipolar carries in active layers arranged in series, which is sometimes called as the cascaded radiative transition. In order to enhance an efficiency of the cascaded radiative transition, energy levels in one active layer are necessary to be aligned with energy levels in active layers next to the one active layer. Specifically, a higher energy level in the one active layer is aligned with a lower energy level in the upstream active layer, and a lower energy level in the one active layer is aligned with a higher energy level in the downstream active layer. Such a cascaded radiative transition may enhance the optical gain in infrared wavelengths, and resultantly, the cascaded radiative transition realizes the laser oscillation in infrared regions. However, the cascaded radiative transition is inevitable to be supplied with a large bias, which resultantly prohibits a cascade layer from operating in reduced biases.

US2013182736 relates to quantum cascade laser includes a substrate having a conductivity type, substrate having a first region, a second region, and a third region; a semiconductor lamination provided on a principal surface of the substrate, the semiconductor lamination including a mesa stripe section provided on the second region, an upper cladding layer having the same conductivity type as the substrate, a first burying layer, and a second burying layer, the mesa stripe section including a core layer; and an electrode provided on the semiconductor lamination. The first and second burying layers are provided on the first and third regions and on both side faces of the mesa stripe section. The upper cladding layer is provided on the mesa stripe section, the first burying layer, and the second burying layer.; The first and second burying layers include a first and second semi-insulating semiconductor regions comprised of a semi-insulating semiconductor material.

EP1 708 318 A1 relates to THz quantum cascade laser is provided that is constituted as a superlattice device by repeatedly overlaying AISb or GaAlSb barrier layers and GaSb quantum well layers (a,b,c,d) and forming electrode layers at the opposite ends thereof. Each repetition unit of the superlattice comprises an injection region and an active region. The thickness of the GaSb layers (c,d) constituting the quantum wells of the active region is adjusted such that the energy difference between the excited state (5) and the ground state (3,4) equals the laser frequency. Efficient extraction of the electrons from the ground state (3,4) of the laser transition is achieved by coupling the ground state (3,4) of the wells (c,d) in the active region with the first excited state (3,4) of a GaSb well (b) in the injection region and by adjusting the thickness of the well (b) in the injection region such that the energy difference between the first excited state (3,4) and the ground state (1,2) is equal to the LO phonon energy of GaSb. The quantum cascade laser lases at lower frequency than conventionally and has a structure that is easy to fabricate.

US2006/065886 A1 relates to a semiconductor apparatus for white light generation and amplification, where, under different current bias, white light can be generated steadily and evenly by folding up multi-wavelength quantum wells and by side-injecting a current. And, the white light can be excited out electronically without mingling with a fluorescent powder so that the cost for sealing is reduced. Because the light is directly excited out by electricity to prevent from energy loss during fluorescence transformation, the light generation efficiency of the present invention is far greater than that of the traditional phosphorus mingled with light-emitting diode of white light.; Besides, concerning the characteristics of the white light, the spectrum of the white light can be achieved by adjusting the structure and/or the number of the quantum wells while preventing from being limited by the atomic emission lines of the fluorescent powder.

US 5 739 543 A relates to an optical semiconductive device of a type wherein current is laterally injected toward the MQW structure to exhibit impartial distribution of carriers, low threshold current, enhanced optical output and improved response speed, in which an active layer has MQW structure, inplanar compression strain is included at least in well layer or barrier. The latent inplanar compression strain produces compressive stress, which serves to vary an energy bandwidth when injecting current in parallel with the MQW structure, so as to lessen effective mass of heavy holes; accordingly, those holes are accelerated, where carriers are impartially distributed to improve the device performance.

### [Summary of Invention]

The invention is defined by the technical features disclosed in the independent claims 1 and 15.

Preferred embodiments are reflected in the dependent claims.

An aspect of the present invention relates to a semiconductor laser that comprises a substrate, an active area, an emitter area, and a collector area, where the active area, the emitter area and the collector area are laterally arranged on a top surface of the substrate such that the emitter area and the collector area sandwich the active area therebetween. The active area provides a quantum well structure. Also, the emitter area has a first conduction type, and the collector area also has the first conduction type same with that of the emitter area. The quantum well structure in the active area causes a radiative transition from a higher energy level to a lower energy level of carriers with the first conduction type. The higher energy level is lower than or equal to an energy level of the carriers in the emitter area, and the lower energy level is higher than or equal to an energy level of the carriers in the collector area.

### [Brief Description of Drawings]

[FIG. 1]

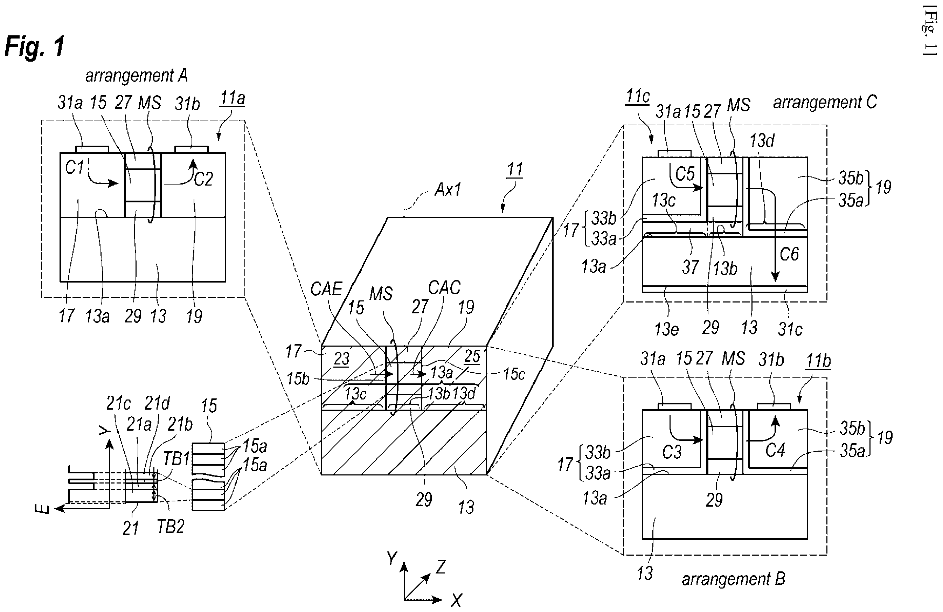

   FIG. 1 schematically illustrates a fundamental arrangement of a semiconductor laser and modified arrangements of a semiconductor laser of the present invention.
[FIG. 2]

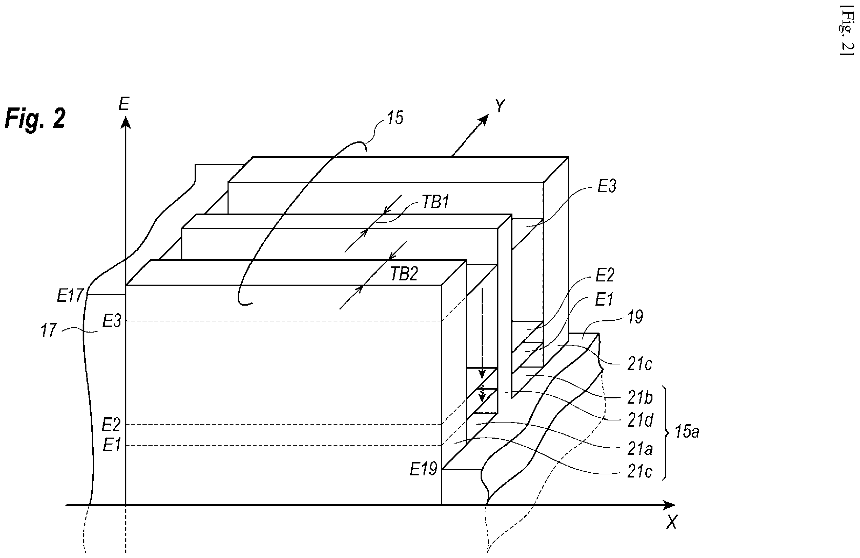

   FIG. 2 schematically illustrates an arrangement of energy levels induced in the quantum well structure in the active area of the semiconductor laser.
[FIG. 3]

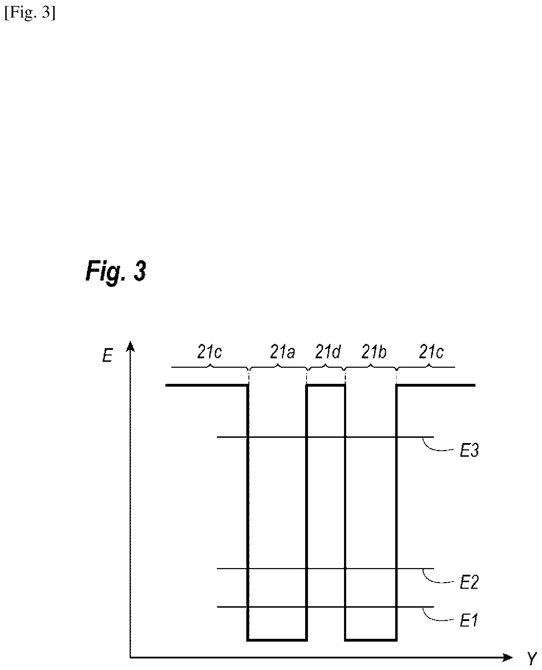

   FIG. 3 illustrates an energy level diagram in the quantum well structure.
[FIG. 4]

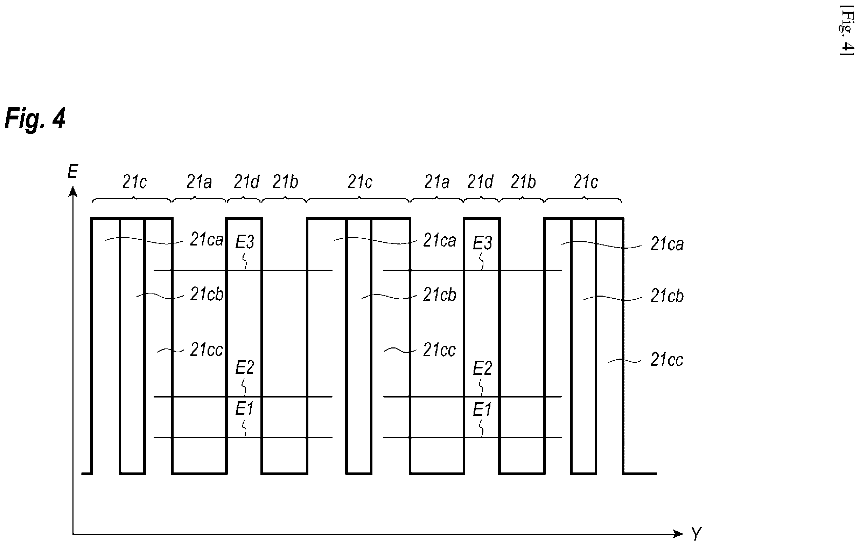

   FIG. 4 illustrates another energy level diagram in the quantum well structure.
[FIG. 5]

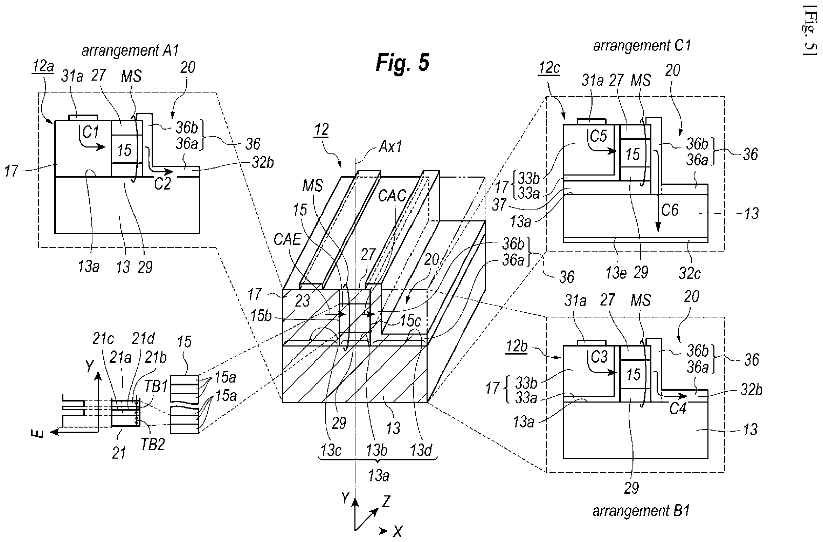

   FIG. 5 schematically illustrates another fundamental arrangement of a semiconductor laser modified from those shown in FIG. 1.
[FIG. 6]

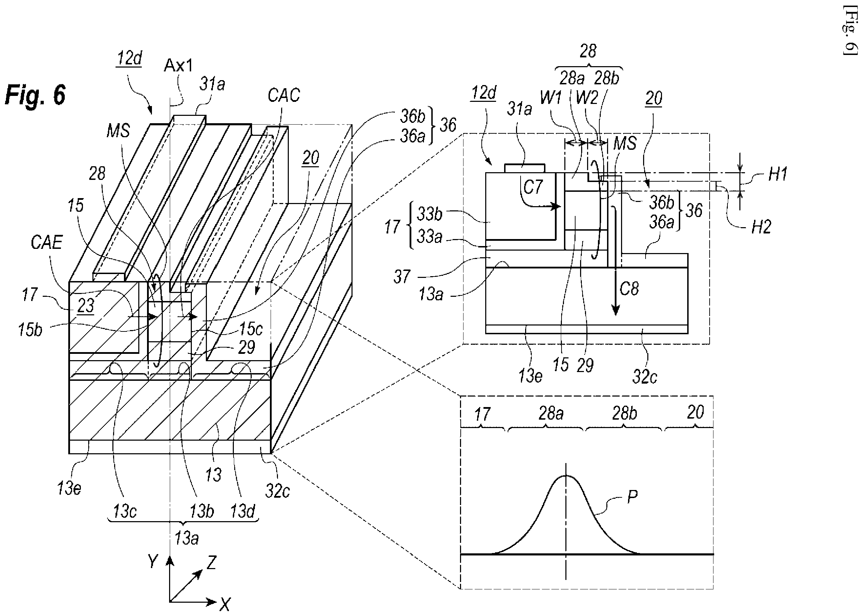

   FIG. 6 illustrates still another arrangement of the semiconductor laser shown in FIG. 5.
[FIG. 7]

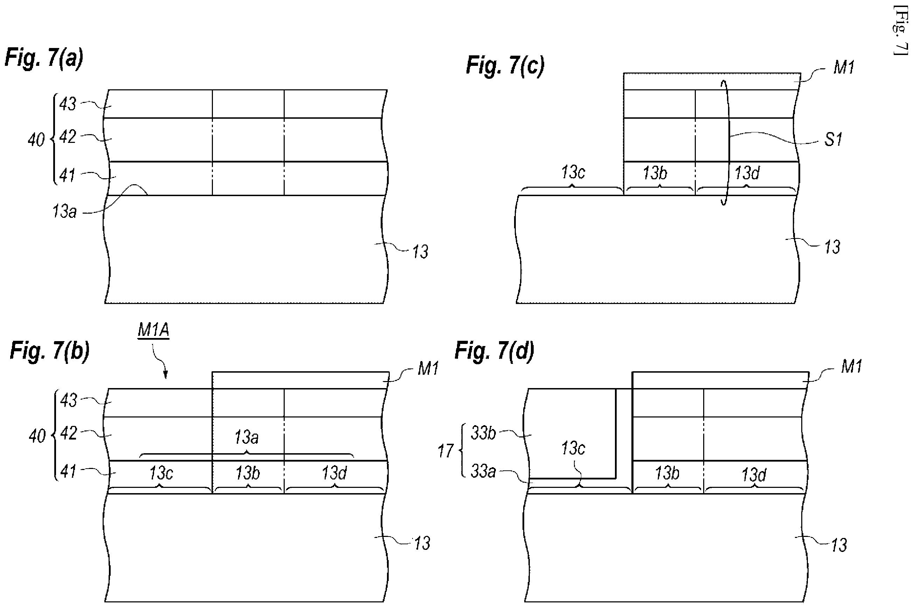

   FIGs. 7(a) to 7(d) schematically illustrate process of forming the semiconductor laser of the present invention shown in FIG. 5.
[FIG. 8]

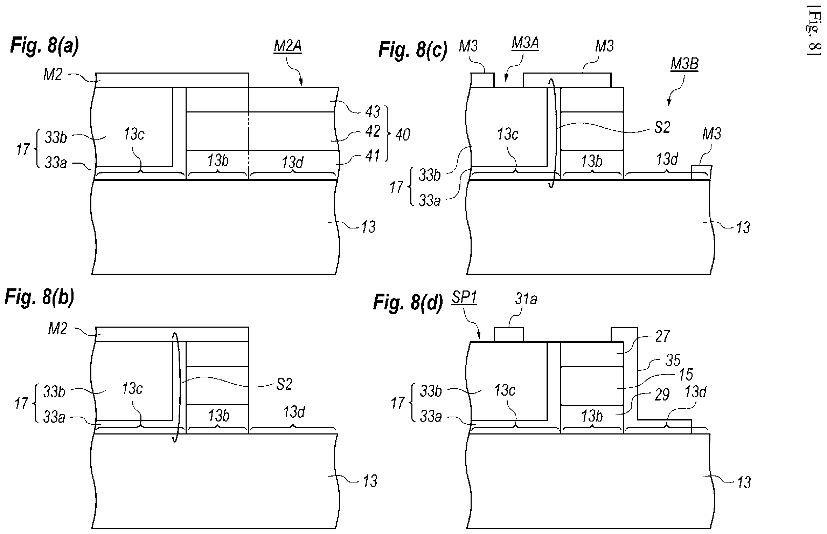

   FIGs. 8(a) to 8(d) schematically illustrate the processes subsequent to that shown in FIG. 7(d).
[FIG. 9]

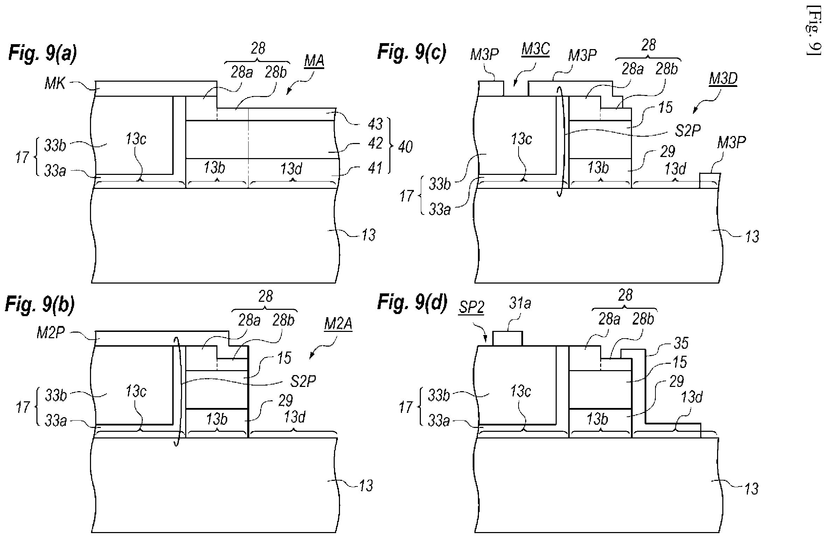

   FIGs. 9(a) to 9(d) schematically illustrate the processes of forming the semiconductor laser shown in FIG. 6.

### [Description of Embodiments]

The semiconductor laser of the present invention injects carriers with the first conduction type from the emitter area into the active area and carries supplied into the active area flows into the collector area after making radiative transitions in the active area. The carries incoming the active area from the emitter area contribute to the emission by the radiative transition from an upper energy level to a lower energy level formed in the quantum well structure. The active area on the first area and the emitter area on the second area are arranged along the second axis intersecting the first axis, while, the active area on the first area and the collector area on the third area are arranged along the third axis intersecting the first axis. Thus, the emitter area in the second area laterally couples with the collector area in the third area through the active area in the first area. The emission from the semiconductor laser of the present invention is only due to the radiative transition within the quantum well structure, and is unnecessary for cascading emissions of the unipolar carriers as those occurring in a cascade laser.

The semiconductor laser of the invention in the quantum well structure thereof provides a first well layer, a second well layer, a first barrier layer, and a second barrier layer, where the first barrier layer demarcates the first well layer from the second well layer, while, the first and second well layers demarcate the first barrier layer from the second barrier layers, respectively. The quantum well structure thus configured provides a higher energy level and a lower energy level for the unipolar carriers. Also, the quantum well structure may further provide a relaxation level lower than the lower energy level. The relaxation level may show a relaxation time for the carriers fallen from the lower energy level which is shorter than a relaxation time for the carrier fallen from the higher energy level to the lower energy level.

The semiconductor laser of the invention may include unit cells sequentially stacked on the substrate, where each of the unit cells includes the first and second well layers, and the first and second barrier layers. A feature of the quantum well structures of the semiconductor laser is that the first barrier layer arranged between the first and second well layers, which may be called as the inner barrier layer, has a thickness less than that of the second barrier layers that sandwich the first and second well layers and the first barrier layer, where the second barrier layers may be called as the outer barrier layers.

The quantum well structure thus configured may couple the first well layer with the second well layer tightly because of the thinned inner barrier layer. Also, the barrier layer may be doped with impurities showing the conduction type same with the conduction type of the carriers.

The present invention may be easily understood by the following explanation referring to accompanying drawings indicated as exemplary examples. Next, some examples of a semiconductor laser and a method of making the semiconductor laser according to the present invention will be described as referring to drawings. In the explanation of the drawings, numerals or symbols same with or similar to each other will refer to elements same with or similar to each other without duplicating explanations.

FIG. 1 schematically illustrates a cross section of a semiconductor laser of one embodiment of the present invention. The semiconductor laser 11 provides a substrate 13, an active area 15, an emitter area 17, and a collector area 19. The substrate 13 provides a top surface 13a that includes a first area 13b, a second area 13c, and a third area 13d. The active area 15, which is provided on the first area 13b, includes a quantum well structure 21 that has a plurality of well layers and a plurality of barrier layers, 21a to 21d. These semiconductor layers, 21a to 21d, are arranged along a first axis Ax1, which is the Y-axis of the Cartesian coordinate; that is, these semiconductor layers, 21a to 21d, are stacked on the top surface 13a of the substrate 13.

The emitter area 17 provides a first semiconductor material 23 with a first conduction type, where the first semiconductor material 23 is arranged on the second area 13c; while, the collector area 19 provides a second semiconductor material 25 with the first conduction type, where the second semiconductor material 25 is arranged on the third area 13d. The first and third areas, 13b and 13d, are arranged along a direction intersecting the first axis Ax1, namely, the positive direction of the X-axis of the Cartesian coordinate. The first and second areas, 13b and 13c, are arranged along the direction, namely, the negative direction of the X-axis of the Cartesian coordinate. Referring to the cross section shown in FIG. 1, the first area 13b is put between the second area 13c and the third area 13d; that is, the second area 13c is spatially apart from the third area 13d by the first area 13a. Accordingly, the emitter area 17 is electrically divided from the collector area 19. Carriers supplied to the emitter area 17 flow within the collector area 19 though the active area 15.

The emitter area 17 is in contact to a side 15b of the active area 15 to supply the carriers with the first conduction type, namely, one of the electrons and the holes. The collector area 19 is also in contact to another side 15c of the active area 15 to receive the carriers with the first conduction type.

The semiconductor laser 11 of the embodiment provides the active area 15 on the first area 13b and the emitter area 17 on the second area 13c each arranged along a direction intersecting the first axis Ax, and the active area 15 on the first area 13b and the collector area 19 on the third area 13d each arranged along a direction also intersecting the first axis Ax. Carriers are supplied from the emitter area 17 to the active area 15 as hot carriers CAE and contribute to the emission in the active area 15 by the radiative transition from the upper energy level of the quantum well structure 21 to the lower energy level of the quantum well structure 21. The carriers after the transition in the active area 15 flow into the collector area 19 as cold carriers CAC. The semiconductor laser 11 of the embodiment utilizes the radiative transition of the carriers with the same conduction type, that is, the semiconductor laser 11 does not utilize the radiative recombination between the electrons and the holes accompanying with the emission. Moreover, the arrangement of the emitter area 17, the active area 15, and the collector area 19, namely, laterally arranged on the substrate 13, makes the cascading transition of the carriers unnecessary. Thus, the semiconductor laser 11 may reduce a bias to operate the semiconductor laser 11.

FIG. 2 schematically illustrates the quantum well structure and the energy levels of the semiconductor laser 11 of the present embodiment The vertical axis corresponds to the energy level E; while, the horizontal axes correspond to the X- and Y- axes shown in FIG. 1. The explanation in FIG. 2 concentrates on the carrier of the type of the electron, but the explanation may be applicable to the carrier of the type of the hole based on the fundamental semiconductor physics.

As FIGs. 1 and 2 show, the active area 15 of the embodiment includes one or more unit cells 15a each comprising a first well layer 21a, a second well layer 21b, a first barrier layer 21c, and a second barrier layer 21d. The second barrier layer 21d, which is the inner barrier layer, divides the first well layer 21a from the second well layer 21b; while, the first well layer 21a and the second well layer 21b divide the first barrier layers 21c, which are the outer barrier layers, from the inner barrier layer 21d, respectively. The unit cell 15a thus arranged may cause discrete energy levels by a width and a depth of the well layers and a width of the inner barrier layer 21d, where the depth of the well layers may be determined by a difference in the energy levels between the well layer and the barrier layer for the carriers under consideration. Specifically, the unit cell 15a of the embodiment, which is formed by two well layers, 21a and 21b, and two barrier layers, 21c and 21d, alternately stacked to each other, causes the upper energy level E3 and the lower energy level E2 each for the electrons, and also a relaxation energy level E1 below the lower energy level E2. The relaxation energy level E3, when it is induced in the well layer, may accelerate non-radiative transition of the carrier from the lower energy level E2 by a relaxation time shorter, preferably far shorter, than a relaxation time for the transition of the carriers from the higher energy level E3 to the lower energy level E2.

The carriers, namely, the electrons in the present embodiment are injected into the active area 15 from the emitter area 17. The injected electrons cause the radiative transition from the upper energy level E3 to the lower energy level E2, which generates light. The electrons falling into the lower level E2 are immediately relaxed to the relaxation level E1 and finally drawn into the collector area 19 therefrom. This mechanism means that the lower energy level E2 shows lesser occupancy of the carriers. Thus, the energy diagram of the present embodiment may accelerate the generation of the population inversion of the carriers.

The unit cells 15a, which is arranged along the stacking direction Ax1, forms the active area 15. The emitter area 17, which is arranged aside of the active area 15, provides the carries concurrently into the respective unit cells 15a. The unit cells 15a, responding the supplement of the carries at the upper energy level E3, causes the radiative transition from the upper energy level E3 to the lower energy level E2, and generates light concurrently. The carriers fallen in the lower energy level E2 are immediately fallen into the relaxation level E1 and flow out to the collector area 19. In order to accelerate the injection of the carriers into the active area 15, the emitter area has an energy level E17, typically the bottom energy level of the conduction band thereof, is substantially equal to or higher than the higher energy level E3 in the well layers, 21a and 21b. Also, in order to enhance the exhaustion of the carriers from the active area 15, the collector area 19 has an energy level E19, which is a bottom energy level of the conduction band thereof, is substantially equal to or lower than the relaxation energy level E1 in the well layers, 21a and 21c.

Within the unit cell 15a, the inner barrier layer 21d partitions two well layers, 21a and 21b. Because the inner barrier layer 21d has a thickness TB1 thinner than a thickness TB2 of the outer barrier layer 21c, the coupling of the well layers, 21a and 21b, may easily occur; exactly, the wave functions attributed to the respective layers, 21a and 21b, oozing into the second barrier layer 21d may effectively couple to each other in the inner barrier layer 21d. Thus, the energy levels may be determined solely by the respective unit cells 15a.

As FIG. 1 indicates, the mesa MS, which includes the active area 15 that extends along the direction Z, physically divides the emitter area 17 from the collector area 19. The mesa MS may also include the first cladding layer 27 as the upper cladding layer on the active area 15. The upper cladding layer 27 preferably has resistivity greater than that of an average resistivity of the active area 15, or the upper cladding layer 27 may be an insulating or semi-insulating layer. The semiconductor laser 11 may also provide the second cladding layer 29 as the lower cladding layer beneath the active area 15. The lower cladding layer 29 preferably has resistivity greater than that in an average of the active area 15, or the lower cladding later may be an insulating or semi-insulating layer. The upper and lower cladding layers, 27 and 29, show not only the function of the optical confinement of the light within the active area 15 but the function of the electrical confinement of the carriers also within the active area 15. Thus, the carries injected from the emitter area 17 may be effectively confined within the active area 15. The upper and lower cladding layers, 27 and 29, may be, as described above, an insulating or semi-insulating layer; but the upper and lower cladding layers, 27 and 29, may have the conduction type opposite to the conduction type of the carriers.

Several arrangements of the semiconductor laser 11 will be described as referring to FIG. 1 again.

### Arrangement A

A semiconductor laser 11a having an arrangement A will be first described. The substrate 13, which may be made of insulating or semi-insulating material, has the top surface 13a. The insulating or semi-insulating characteristic of the substrate 13 may effectively isolate the collector area 19 from the emitter area 17. The first area 13b of the top surface 13a stacks the lower cladding layer 29, the active area 15, and the upper cladding area 27 thereon. The emitter area 17 on the second area 13c, where the emitter area may be made of a semiconductor material 23 of the first conduction type, is in physically contact to the side of the lower cladding area 29, that of the active area 15, and that of the upper cladding area 27. The collector area 19, which is provided on the third area 13d and may be made of semiconductor material 25 with the first conduction type, is in physically contact to the other side of the lower cladding area 29, that of the active area 15, and that of the upper cladding layer 27. The semiconductor laser 11a further provides a first electrode 31a on the emitter area 17 and a second electrode 31b on the collector area 31b, where the first and second electrodes, 31a and 31b, may form non-rectifier contacts to the emitter area 17 and the collector area 19, respectively. An arrow C1 indicated in FIG. 1 denotes a flow of the carriers in the emitter area 17, while another arrow C2 denotes a flow of the carriers in the collector area 19. Thus, the emitter area 17 and the collector area 19 are laterally arranged on the substrate 13; accordingly, the first and second electrodes, 31a and 31b, may be arranged apart from the mesa MS where the mesa MS propagates the light having relatively longer wavelength.

### Arrangement B

The substrate 13 of the arrangement B may be made of also insulating or semi-insulating material and has the top surface 13a. The first area 13b stacks the lower cladding layer 29, the active area 15, and the upper cladding layer 27 thereon. The emitter area 17 on the second area 13c provides a first semiconductor layer 33a that is in physically contact to the side of the mesa MS and a second semiconductor layer 33b on the first semiconductor layer 33a. The first semiconductor layer 33a, as FIG. 2 indicates, may be made of a semiconductor material having the conduction band in the bottom level thereof substantially equal to or higher than the upper energy level E3, which enables the carrier injection from the emitter area 17 into the active area 15 without supplying a large bias. The second semiconductor layer 33b may be made of semiconductor material having refractive index smaller than equivalent refractive index of the active area 15.

The collector area 19 on the third area 13d may include a third semiconductor layer 35a that is in physically contact to the other side of the mesa MS, and a fourth semiconductor layer 35b on the third semiconductor layer 35a. The third semiconductor layer 35a, as FIG. 2 indicates, may be made of semiconductor material having the conduction band in the bottom energy level thereof equal to or lower than the lower level E2, or preferably lower than the relaxation level E1. Thus, the semiconductor laser 11b of the arrangement B enhances the extraction of the carriers into the collector area 19 from the active area 15. The fourth semiconductor layer 35b may be made of semiconductor material having refractive index smaller than equivalent refractive index of the active area 15. The semiconductor laser 11b further provides the first electrode 31a and the second electrode 31b on the emitter area 17 and the collector area 19, where the electrodes, 31a and 31b, each make non-rectifier contacts to the respective areas, 17 and 19. An arrow C3 indicates the carrier flowing in the emitter area 17, while, another arrow C4 indicates the carrier flowing in the connector area 19.

### Arrangement C

Still another arrangement of the semiconductor laser 11c will be described. The semiconductor laser 11c provides an electrically conductive substrate 13. Because of the conductive characteristic of the substrate 13, the semiconductor laser 11c is necessary to isolate the emitter area 17 electrically from the substrate 13. Accordingly, the semiconductor laser 11c provides an isolation area 37 on the substrate 13 in the first area 13b and the second area 13c, where the isolation area 37 is made of electrically insulating or semi-insulating material and may electrically isolate the active area 15 and the emitter area 17 from the substrate 13. The isolation area 37 may operate as a lower cladding layer. In such a case, the lower cladding layer 29 may be omitted. The first area 13b of the substrate 13 stacks the lower cladding layer 29, the active area 15, and the upper cladding layer 27 thereon as interposing the isolating isolation area 37 against the substrate 13. The emitter area 17 on the second area 13c, which has the first conduction type, is in physically contact to the side of the lower cladding layer 27 and that of the active area 15. The collector area 19 on the third area 13d, which also has the first conduction type, is in physically contact to a side of the isolation area 37, the other side of the lower cladding layer 29, and the other side of the active area 15. The semiconductor laser 11c of the present embodiment provides the first and second semiconductor layers, 33a and 33b, in the emitter area 17, where the first semiconductor layer 33a is in contact to the side of the mesa MS. Also, the collector layer 19 provides the third and fourth semiconductor layers, 35a and 35b, where the third semiconductor layer 35a is in contact to the other side of the mesa MS. The emitter area 17, exactly, the second semiconductor layer 33b in the emitter area 17, provides the first electrode 31a thereon, which is similar to those of the arrangement B; but, a third electrode 31c instead of the second electrode 31b of the arrangement B is provided in a back surface 13e of the substrate 13. The third electrode 31c makes non-rectifier contact to the back surface 13e of the substrate 13. Arrows, C5 and C6, indicated in FIG. 1 show the carrier flowing from the first electrode 31a to the third electrode 31c.

### First Embodiment

Next, the quantum well structure will be described as referring to FIG. 3. Although the explanation below concentrates on a case where the carriers are electrons, the same may be applicable to another case where the carriers are holes. In order to enhance the probability of the radiative transition from the upper energy level E3 to the lower energy level E2, the reduction of the occupancy by the carriers in the lower energy level E2 is effective. One example of the quantum well structure 21 provides well layers, for instance, two well layers, 21a and 21b, and one or more barrier layers to divide these well layers. The inner barrier layer 21d is thinner than the outer barrier layer 21c to tightly couple the wave functions in the respective well layers, 21a and 21b, that penetrate into the inner barrier layer 21d. Such a structure is often called as the coupled quantum well. The coupled quantum well, as FIG. 3 indicates, provides an arrangement of the line symmetry with respect to a center of the inner barrier layer 21d. Such an arrangement may form the relaxation level E1 lower than the lower energy level E2 by an amount substantially equal to energy of an LO phonon. The carriers fallen into the lower energy level E2 from the upper energy level E3 may immediately fall to the relaxation level E1 by the phonon scattering. Also, the coupled quantum well may enhance the overlapping of the wave function attributed to the upper energy level E3 with the wave function of the lower energy level E2, which may increase the probability of the radiative transition between the levels, E3 and E2, and resultantly the efficiency of the laser emission. Table below summarizes parameters of the coupled quantum well of the embodiment.

| | | |
|---|---|---|
| well layers | undoped InGaAs | 4 nm |
| barrier layers | undoped AlInAs | |
| | inner barrier layer (21d) | 2 nm |
| | outer barrier layers (21c) | 10 nm |
| substrate | InP | |
| energy difference (E3-E2) | 270 meV (λ = 4.6 µm) | |
| energy difference (E2-E1) | 35.6 meV | |
| optical gain | 96 cm⁻¹/cell | |

The semiconductor laser of the type of the present invention is unnecessary to accompany the active area with an injection layer that is inevitable in a semiconductor layer having a type of the cascade quantum well structure, which may expand a range of variation of the quantum well structure. Also, the coupled quantum well of the embodiment may induce tensile stress in the barrier layers, 21c and 21d, while, compressive stress in the well layers, 21a and 21b, by adjusting lattice constants of respective layers, 21a to 21d, these two stresses may be totally and substantially compensated in the whole coupled quantum well. This enables to obtain a large difference between the energy levels without degrading crystal quality. A larger difference ion the energy levels results in the suppression of the leaking of carriers, which means to improve temperature characteristics of the semiconductor laser and the range of the oscillation wavelength.

Next, a process of forming the semiconductor laser will be described. First, a substrate made of indium phosphide (InP) is prepared. The process next grows on the InP substrate another InP layer doped with iron (Fe) for the lower cladding layer 29. On the Fe-doped InP layer, the process grows the active area 15 including the unit cells 15a having four semiconductor layers, 21a to 21d, described above. Then, another Fe-doped InP layer for the upper cladding layer 27 is grown on the active area 15. Thus, the semiconductor stack may be provided on the substrate 13. Forming a first mask preferably made of silicon nitride (SiN) on a top surface of the semiconductor stack, a portion of the semiconductor stack is etched using the first mask as an etching mask, where the first mask covers a portion of the mesa MS and the collector area 19 so as to expose the semiconductor stack for the emitter area 17. Sequentially growing a silicon (Si) doped aluminum indium arsenide (Si-AlInAs) and silicon doped indium phosphide (Si-InP) within the emitter area 17 thus formed by the etching, the emitter area 17 may be completed. The Si-AlInAs layer preferably has a thickness through which electrons are hard to be tunneled, that is, the Si-AlInAs layer is preferably thicker than 10 nm.

Removing the first mask, the process forms a second mask that covers the emitter area 17 and the semiconductor stack for the mesa MS. A portion of the semiconductor stack exposed from the second mask is etched and the mesa MS may be formed. Sequentially growing a silicon (Si) doped InGaAs (Si-InGaAs) and another Si-InP in an area thus etched in the previous process to form the collector area 19. The Si-GaInAs preferably has a relatively thinner thickness of 10 to 50 nm, which strengthens the optical confinement laterally and stabilizes the transverse mode of the laser emission.

After the formation of the emitter area 17, the active area 15, and the collector area 19, the process forms the n-type electrodes, 31a and 31b, on the emitter area 17 and the collector area 19, respectively, by for instance, the metal evaporation and subsequent lift-off technique. Then, grinding the back surface of the substrate 13, and cleaving thus thinned substrate 13, laser bars each including the semiconductor lasers are formed. If necessary, the process may interpose a semiconductor material between the first and second semiconductor layers in the emitter area 17, where the semiconductor material has intermediate bandgap energy between the Si-doped InP and the Si-doped AlInAs to form a stack of InP/AlGaInAs/AlInAs, where AlGaInAs has bandgap energy between those of InP and AlInAs. Also, the collector area 19 may have a stacking of InP/GaInAsP/GaInAs, where GaInAsP has bandgap energy between those of InP and GaInAs. Those intermediate semiconductor materials, AlGaInAs in the emitter area 17 and GaInAsP in the collector area 19, may moderate respective hetero interfaces and enable the semiconductor laser operable in relatively lower biases.

For another semiconductor laser having an electrically conductive substrate, that is, the semiconductor laser having the arrangement C in FIG. 1, the process may first grow a semi-insulating InP layer on the conductive substrate 13. Then, a portion of the semi-insulating layer corresponding to the collector area 19 is removed to expose the conductive substrate 13. Thereafter, similar to the aforementioned processes, forming the semiconductor stack for the lower cladding layer 29, the active area 15, and the upper cladding layer 27; etching a portion of the semiconductor stack, re-growing the semiconductor layers; the semiconductor laser having the arrangement C may be completed.

### Second Embodiment

As FIG. 4 indicates, the quantum well structure of the second embodiment of the present invention may dope impurities showing the conduction type same with that of the carriers within at least a portion of the barrier layers. The barrier layer partially doped may enhance the injection efficiency of the carriers into the well layers. Specifically, the barrier layer made of AlInAs with the thickness of 10 nm, which corresponds to the barrier layers 21c set in outer sides in FIG. 3, may include layers, 21ca and 21cc, in contact to the well layers, 21a and 21b, and another layer 21cb between the former layers, 21ca and 21cc, where the former layers, 21ca and 21cc, is un-doped but the latter layer 21cb is doped with impurities causing the conduction type of the carriers. The intermediate layer 21cb may have doping density of preferably less than 10¹⁷ cm⁻³ to suppress optical losses due to the free carrier absorption. The intermediate layer 21cb may enhance the lateral conductivity within the layer, where the carriers injected from the emitter area 17 may reach regions in the well layers apart from the emitter area 17.

### Third Embodiment

FIG. 5 shows still another arrangement of the semiconductor laser of the present invention, which are modified from the arrangements shown in FIG. 1. The semiconductor laser 12 shown in FIG. 5 has features distinguishable from the semiconductor laser 11 shown in FIG. 1 that the semiconductor laser 12 has an electrode area 20 as the collector area 19 of the aforementioned semiconductor laser 11. Other arrangements in the semiconductor laser 12 are substantially same with those of the aforementioned semiconductor laser 11. The electrode area 20, which is formed on the third area 13d of the top surface 13a of the substrate 13, provides a metal 36 extending along the direction Z and in contact to the active area 15. The emitter area 17 and the electrode area 20 area divided by the mesa MS, and the carries injected into the emitter area 17 flow into the electrode area 20 through the active area 15.

Specifically, the carriers injected into the emitter area 17 are supplied to the active area 15 in the higher energy level as the carriers CAE, cause the radiative emission from the higher energy level to the lower energy level in the active area 15, and finally stream into the metal 36 in the electrode area 20. Thus, the semiconductor laser 12 may show the function of the radiative transition by the unipolar carriers without providing the cascaded radiative transition also by the unipolar carriers.

As FIG. 5 illustrates, the active area 15, which may be formed within he mesa MS, may include the upper cladding layer 27 as the first cladding layer and the lower cladding layer 29 as the second cladding layer, where the active area 15 is sandwiched between the upper and lower cladding layers, 27 and 29. The upper cladding layer 27 may have the resistivity greater than that of the active area 15 in an average thereof, and the lower cladding layer 29 may also have the resistivity greater than that of the active area in an average thereof. Because the upper and lower cladding layers, 27 and 29, have a function to confine carries electrically within the active area in addition to the function to confine light within the active layer, the carrier injection from the emitter area 17 into the active area 15 may be effective. The upper and lower cladding layers, 27 and 29, may be preferably made of insulating and/or semi-insulating material, or semiconductor material having the conduction type thereof opposite to the carriers; specifically, when the carriers are electrons, the upper and lower cladding layers, 27 and 29, may be made of p-type semiconductor material. The electrode area 20, in particular, the metal 26 thereof is in contact to the side 15c of the active area 15 and form the non-rectified contact against the active area 15.

The upper and lower cladding layers, 27 and 29, have refractive indices thereof smaller than refractive index of the active area 15 in an average. Also, the emitter area 17 has refractive indices smaller than the average refractive index in the active area 15. Thus, this arrangement of the refractive index in the emitter area 17 and the active area 15 may laterally confine light generated in the active area 15; while, the arrangement of the upper and lower cladding layers, and the active area 15 may vertically confine the light within the active area 15.

Several modifications of the semiconductor laser 12 will be described as referring back to FIG. 5.

### Arrangement A1

The arrangement A1 for the semiconductor laser 12a, which traces the semiconductor laser 12, provides the metal 36 including a first portion 36a and a second portion 36b, where the second portion 36b is in contact to the side 15c of the mesa MS, namely, the side of the upper and lower cladding layers, 27 and 29, and that of the active area 15. The first portion 36a is directly in contact to the top surface 15a of the substrate 15. The semiconductor laser 12a further provides the first electrode 31a in the top of the emitter area 17, while the first portion 36a of the metal 36 gives the function of the second electrode 32b. The carriers C1 injected from the first electrode 31a into the emitter area 17 come within the active area 15 and the active area 15 exhausts the carriers C2 into the second portion 36b of the metal.

### Arrangement B1

The arrangement B1, which corresponds to the arrangement B in FIG. 1, has a feature that the emitter area 17 provides two portions, 33a and 33b, where the former portion 33a is directly in contact to the top surface 13a of the substrate 13 and the side 15b of the mesa MS, namely, the sides of the upper and lower cladding layers, 27 and 29, and the side of the active area 15; while, the latter portion 33b is provided on the first portion 33a. The first portion 33a, as shown in FIG. 2 gives the energy level E17 of the bottom of the conduction band that is substantially equal to or higher than the upper energy level E3 in the well layers, 21a and 21b. The second portion 33b has the refractive index smaller than the equivalent refractive index of the active area 15. Thus, the arrangement of the double semiconductor layers, 33a and 33b, may enhance the carrier injection into the well layers, 21a and 21b, in the active area 15 without degrading the optical confinement within the active area 15, where the arrows, C3 and C4, indicate the carrier flowing from the first electrode 31a to the second electrode 32b as those in the arrangement B of the aforementioned embodiment.

### Arrangement C1

The arrangement C1 in FIG. 5, which corresponds to the arrangement C in FIG. 1, has a feature that the substrate 13 is electrically conductive and the second electrode 32c is provided in the back surface 13e of the substrate 13. Because of the electrical isolation of the emitter area 17 and the mesa MS from the second electrode 32c, the semiconductor laser 12c provides the isolation area between the emitter area 17 and the substrate 13, and between the mesa MS and the substrate 13, that is, the isolation area 37 is provided beneath the emitter area 17 and the mesa MS. Removing the lower cladding layer 29, the isolation area 37 in a portion beneath the mesa MS may show the function of the lower cladding layer. The emitter area 17, similar to the arrangement B1, provides the double layers, 33a and 33b, made of semiconductor materials whose functions are same with those in the arrangement B1.

### Arrangement D

Still another arrangement is described as referring to FIG. 6. The semiconductor laser 12d also provides the electrically conductive substrate 13 and the isolation area 37 to isolate the emitter area 17 and the mesa MS electrically from the substrate 13. The isolation area 37 may show the function of the lower cladding layer 29 against the active area 15. In such a case, the lower cladding layer 29 may be removed.

The semiconductor laser 12d provides an upper cladding layer 28 that includes a first portion 28a and a second portion 28b, where the former portion 28a is in contact to the emitter area 17, while, the latter portion 28b is in contact to the electrode area 20. A feature of the upper cladding layer 28 of the embodiment is that the first portion 28a has a thickness H1 greater than a thickness H2 of the second portion 28b. Specifically, the former thickness H1 may be, for instance, 1 to 5 µm, while the latter thickness H2 is, for instance, 0.2 to 2.0 µm. The first and second portions, 28a and 28b, may have widths, W1 and W2, from 1 to 5 µm, where the former width W1 of the first portion 28a is wider than the latter width W2 of the second portion 28b. Accordingly, the light propagating along the mesa MS may show a profile P whose peak is offset toward the emitter area 17.

### Fourth Embodiment

Next, processes of forming the semiconductor lasers, 12a to 12d, according to the modified arrangements will be described. As FIG. 7 indicates, the process first grows semiconductor layers, 41 to 43, for the lower cladding layer 29, the active area 15, and the upper cladding layer 27 sequentially on the substrate 13 by, for instance, the MOCVD or MBE technique. The layer 41, which is grown for the lower cladding layer 29, may made of InP doped with irons (Fe). The layer 42 includes unit cells each having four layers of the quantum well structure. The layer 43 may be also made of InP doped with irons. Thus, the semiconductor stack 40 for the mesa MS is formed.

Then, the process prepares a first mask M1, which may be made of silicon nitride (SiN), on the semiconductor stack 40 for forming the first stripe S1, FIG. 7(b). The first mask M1 provides an opening M1A above the second area 13c. A portion of the semiconductor stack 40 exposed in the opening M1A is fully etched so as to expose the top surface 13a of the substrate 13, which forms the first stripe S1 as shown in FIG. 7(c). Subsequently, the process carries out the selective growth in the second area 13c without removing the first mask M1 left on the first stripe S1, as shown in FIG. 7(d). The selective growth sequentially grows the first semiconductor layer 33a, which may be made of silicon (Si) doped AlInAs, and the second semiconductor layer 33b, which may be made of also Si doped InP. The first semiconductor layer 33a preferably has a thickness for electrons not to tunnel therethrough, specifically, thicker than 10 nm. After the selective growth of the semiconductor layers, 33a and 33b, the process removes the first mask M1.

Then, the second stripe S2 is formed. As FIG. 8(a) indicates, the process prepares the second mask M2, which may be made of also silicon nitride (SiN), on the emitter area 17 and the semiconductor stack 40. The second mask M2 provides an opening M2A in a portion corresponding to the electrode area 20, within which the top surface of the semiconductor stack 40 is exposed. Using the second mask M2 thus prepared, the process removes a part of the semiconductor stack 40 corresponding to the electrode area 20 until the top surface 13a of the substrate 13 appears. After the removal of the semiconductor stack 40, the second mask M2 is removed as shown in FIG. 8(b). Subsequently, the process prepares a third mask M3, which is shown in FIG. 8(c), where the third mask M3 , which may be made of resin, typically a photoresist, provides an opening M3A on the emitter area 17 and another opening M3B in the electrode area 20. The first electrode 31a is deposited within the opening M3A, which is on the second semiconductor layer 33b in the emitter area 17, and the metal 36 is deposited within the other opening M3B on the substrate 13 each by sequential processes of the metal evaporation and the subsequent lift-off technique that removes portions of the evaporated metal left on the third mask M3 concurrently with the removal of the third mask M3. Thus, an intermediate device SP1 for the semiconductor laser 12 may be obtained, as shown in FIG. 8(d).

Grinding the back surface of the substrate 13, and cleaving the substrate 13, laser bars each including semiconductor lasers may be formed. The process for the semiconductor laser 12 thus described may further grow, in the step shown in FIG. 7(c), an intermediate semiconductor layer between the first and second semiconductor lasers, 31a and 31b. The intermediate semiconductor layer has bandgap energy between those of AlInAs of the first semiconductor layer 33a and InP of the second semiconductor layer 33b, where the intermediate semiconductor layer may be made of AlGaInAs as a typical example. Such an arrangement of the semiconductor layers in the emitter area 17 may effective reduce the band offset between the first and second semiconductor layers, 33a and 33b, and the semiconductor laser 12 may be operable in further reduced biases.

Next, another process of forming the semiconductor laser 12d shown in FIG. 6 will be described as referring to FIGs. 9A to 9D. Subsequent to the processes from that shown in FIG. 7(a) to that shown in FIG. 7(d), that is, after forming the first stripe S1 and removing the first mask M1, the process prepares a mask MK, which may be made of also silicon nitride (SiN), on the emitter area 17 and the semiconductor stack 40. The mask MK provides an opening MA that exposes a portion of the top surface of the semiconductor layer 43 in the first area 13b and the top surface of the semiconductor layer 43 in the third area 13d. Using the mask MK, the third semiconductor layer 43 is half etched, as shown in FIG. 8(a). That is, the etching does not expose the second semiconductor layer 43. After the partial etching of the third semiconductor layer 43, the process fully removes the mask MK. Then, the second mask M2P, which may be made of silicon nitride (SiN), covers the first area 13b and the second area 13c. That is, the second mask M2P exposes the top surface of the third semiconductor layer 43 in the third area 13d, where the exposed third semiconductor layer 43 is half etched in the preceding step. Then, the third to first semiconductor layers, 43 to 31, on the third area 13d are sequentially etched using the second mask M2P so as to exposes the substrate 13, which forms the second stripe S2P as shown in FIG. 9(b). After the etching, the process fully removes the second mask M2P.

Next, as FIG. 9(c) indicates, the process further prepares still another mask M3P, which may be made of resin, typically a photoresist, that provides an opening M3C in the second area 13c for forming the electrode 31a and another opening M3D in the third area 13d for forming the metal 36. Deposition of the metal within the openings, M3C and M3D, by the metal evaporation and the subsequent lift-off process form the electrode 31d and the metal 36 in respective areas, 13c and 13d. Thus, the intermediate device SP2 for the semiconductor laser 12d may be formed. Grinding the back surface of the substrate and cleaving the substrate, laser bars each including the semiconductor lasers are completed.

When the semiconductor lasers 12c which provides the electrode 32c in the back surface of the electrically conductive substrate 13, the process for forming the semiconductor stack 40 grows an semi-insulating InP directly on the substrate 13 in advance to grow the first semiconductor layer 41. Then, portions of the semi-insulating InP layer in the third area 13d are removed by the sequential processes of the photolithography and the selective etching of the semi-insulating InP layer in the third area. Then, the process may form the semiconductor stack for the mesas, S1 and S2, perform the processes subsequent to that shown in FIG. 7(b). In an alternative, the process may leave the semi-insulating InP layer and grow the semiconductor layers, 41 to 43, for the semiconductor stack 40 on the left semi-insulating InP layer; but, the process shown in FIG. 8(c) or 9C etches not only the semiconductor layers, 41 to 43, in the third area 13d but the semi-insulating InP layer left beneath the first semiconductor layer 41 so as to expose the surface of the conductive substrate 13. Thus, the semiconductor laser 12c having the conductive substrate 13, or the back electrode 32c may be obtained.

The semiconductor laser according to the present invention has a feature distinguishable from those of quantum cascade lasers in that the injected carriers are laterally transported within the well layers, which means that no potential barriers exist along the transportation of the carriers. Accordingly, the semiconductor layer of the invention may be operable by relatively lower biases. Also, the semiconductor laser of the invention may enhance the optical gain by providing a plurality of the quantum well structure 21 without increasing the operational bias. Even the semiconductor layer provides a lot of unit cells each having the quantum well structure 21 to enhance the optical gain thereof, the operational bias is unnecessary to be increased. Thus, the semiconductor laser of the invention may save power consumption compared with conventional cascade lasers that show lesser efficiency due to the tunneling of the carriers through the barrier layers.

In the foregoing detailed description, the method and apparatus of the present invention have been described with reference to specific exemplary embodiments thereof. It will, however, be evident that various modifications and changes may be made thereto without departing from the scope of the present invention. The present specification and figures are accordingly to be regarded as illustrative rather than restrictive.

## Claims

1. A semiconductor laser (11), comprising:
a substrate (13);
an active area (15) provided on the substrate, the active area including a quantum well structure (21);
an emitter area (17) provided on the substrate, the emitter area having a first conduction type; and
a collector area (19) provided on the substrate, the collector area having the first conduction type, wherein the quantum well structure causes a radiative transition of carrier of the first conduction type between a higher energy level (E3) to a lower energy level (E2), the higher energy level being lower than or equal to an energy level (E17) of the carriers in the emitter area, the lower energy level being higher than or equal to an energy level (E19) of the carriers in the collector area
**characterized in that**
the active area, the emitter area and the collector area are laterally arranged on a top surface (13a) of the substrate such that the emitter area and the collector area sandwich the active area therebetween.

2. The semiconductor laser of claim 1,
wherein the quantum well structure includes at least one unit cell (15a) comprising two well layers (21a, 21b), an outer barrier layer (21c), and an inner barrier layer (21d), the inner barrier layer being arranged between the well layers, the well layers being arranged between the inner barrier layer and the outer barrier layer,
wherein the well layers, the outer barrier layers, and the inner barrier layer are stacked on the substrate.

3. The semiconductor laser of claim 2,
wherein the quantum well structure includes a plurality of unit cells each sequentially stacked on the substrate, and
wherein the outer barrier layers in the respective unit cells have thicknesses greater than a thickness of the inner barrier layer in the respective unit cells.

4. The semiconductor laser of claim 3, wherein the outer barrier layers, the inner barrier layer, and the well layers in the respective unit cells have thicknesses of 10 nm, 2 nm, and 4 nm, respectively.

5. The semiconductor laser of claim 3, wherein the well layers are made of InGaAs, and the inner barrier layer and the outer barrier layers are made of AllnAs.

6. The semiconductor laser of claim 3, wherein the quantum well structure further provides a relaxation energy level (E1) lower than the lower energy level but equal to or higher than the energy level of the carriers in the collector area.

7. The semiconductor laser of claim 6, wherein the higher energy level and the lower energy level have a difference greater than a difference between the lower energy level and the relaxation energy level.

8. The semiconductor laser of claim 2 wherein the outer barrier layers are doped with impurities showing the first conduction type.

9. The semiconductor laser of claim 1,
further including a lower cladding layer (29) and an upper cladding layer (27) sandwiching the active area therebetween;
wherein the lower cladding layer, the active area, and the upper cladding layer form a mesa (MS) arranged between the emitter area and the collector area on the substrate, the emitter area being in contact to a side of the mesa, the collector area being in contact to another side of the mesa,
wherein the upper cladding layer and the lower cladding layer electrically confine the carriers coming from the emitter area and outgoing to the collector area within the active area.

10. The semiconductor laser of claim 9, wherein the lower cladding layer and the upper cladding layer optically confine light within the active area, where the light is generated in the well layers by the radiative transition of the carriers.

11. The semiconductor laser of claim 9, wherein the emitter area includes a first semiconductor layer (33a) and a second semiconductor layer (33b), the first semiconductor layer being directly in contact to the side of the mesa and a top surface of the substrate, the second semiconductor layer being provided on the first semiconductor layer.

12. The semiconductor laser of claim 9, wherein the emitter area provides a first electrode (31a) and the collector area provides a second electrode (31b), the carries being injected into the active area from the first electrode through the emitter area and extracted to the second electrode through the collector area.

13. The semiconductor laser of claim 12, wherein the collector area provides a third semiconductor layer (35a) and a fourth semiconductor layer (35b), the third semiconductor being directly in contact to the another side of the mesa.

14. The semiconductor laser of claim 11,
further including an isolation area (37) between the substrate and the emitter area, and between the substrate and the mesa, the isolation area electrically isolating the emitter area and the mesa from the substrate,
wherein the emitter area provides a first electrode, and
wherein the substrate is made of electrically conductive material, and a second electrode is provided in a back surface (13e) of the substrate.

15. A semiconductor laser (12, 12d), comprising:
a substrate (13);
an active area (15) provided on the substrate, the active area including a quantum well structure (21);
an emitter area (17) provided on the substrate, the emitter area having a first conduction type; and
a collector area (20) provided on the substrate; and
a lower cladding layer (29) and an upper cladding layer (27, 28) sandwiching the active area therebetween;
wherein the lower cladding layer, the active area, and the upper cladding layer form a mesa (MS) arranged between the emitter area and the collector area on the substrate, the emitter area being in contact to a side of the mesa, the collector area being in contact to another side of the mesa,
wherein the upper cladding layer and the lower cladding layer electrically confine the carriers coming from the emitter area and outgoing to the collector area within the active area,
wherein the quantum well structure causes a radiative transition of carrier of the first conduction type between a higher energy level (E3) to a lower energy level (E2), the higher energy level being lower than or equal to an energy level (E17) of the carriers in the emitter area,
wherein the emitter area provides a first electrode (31a) and the collector area provides a second electrode (36), the carries being injected into the active area from the first electrode through the emitter area and extracted to the second electrode through the collector area, and
wherein the second electrode in the collector area is directly in contact to the another side of the mesa without interposing any semiconductor materials,
**characterized in that**
the active area, the emitter area and the collector area are laterally arranged on a top surface (13a) of the substrate such that the emitter area and the collector area sandwich the active area therebetween.

16. The semiconductor laser of claim 15,
wherein the upper cladding layer (28) provides a first portion (28a) and a second portion (28b), the first portion being directly in contact to the emitter area and the second portion being directly in contact to the second electrode in the collector area, and
wherein the first portion has a thickness greater than a thickness of the second portion.

17. The semiconductor laser of claim 15,
wherein the emitter area includes a first semiconductor layer (33a) and a second semiconductor layer (33b), the first semiconductor layer being in directly contact to the mesa and the substrate, the second semiconductor layer being provided on the first semiconductor layer, the first electrode being provided on the second semiconductor layer.

## Patentansprüche

1. Halbleiterlaser (11), umfassend:
ein Substrat (13);
einen aktiven Bereich (15), der auf dem Substrat vorgesehen ist, wobei der aktive Bereich eine Quantentopfstruktur (21) enthält;
einen Emitterbereich (17), der auf dem Substrat vorgesehen ist, wobei der Emitterbereich einen ersten Leitfähigkeitstyp aufweist; und
einen Kollektorbereich (19), die auf dem Substrat vorgesehen ist, wobei der Kollektorbereich den ersten Leitfähigkeitstyp aufweist, wobei die Quantentopfstruktur einen Strahlungsübergang von Ladungsträgern des ersten Leitfähigkeitstyps zwischen einem höheren Energieniveau (E3) zu einem niedrigeren Energieniveau (E2) bewirkt, wobei das höhere Energieniveau niedriger oder gleich einem Energieniveau (E17) der Ladungsträger in dem Emitterbereich ist, wobei das niedrigere Energieniveau höher oder gleich einem Energieniveau (E19) der Ladungsträger in dem Kollektorbereich ist,
**dadurch gekennzeichnet, dass**
der aktive Bereich, der Emitterbereich und der Kollektorbereich seitlich auf einer Oberseite (13a) des Substrats angeordnet sind, so dass der Emitterbereich und der Kollektorbereich den aktiven Bereich zwischen sich einschließen.

2. Halbleiterlaser nach Anspruch 1,
wobei die Quantentopfstruktur mindestens eine Einheitszelle (15a) umfasst, die zwei Topfschichten (21a, 21b), eine äußere Sperrschicht (21c) und eine innere Sperrschicht (21d) umfasst, wobei die innere Sperrschicht zwischen den Topfschichten angeordnet ist und die Topfschichten zwischen der inneren Sperrschicht und der äußeren Sperrschicht angeordnet sind,
wobei die Topfschichten, die äußeren Sperrschichten und die innere Sperrschicht auf dem Substrat gestapelt sind.

3. Halbleiterlaser nach Anspruch 2,
wobei die Quantentopfstruktur eine Vielzahl von Einheitszellen enthält, die jeweils der Reihe nach auf dem Substrat gestapelt sind, und
wobei die äußeren Sperrschichten in den jeweiligen Einheitszellen Dicken aufweisen, die größer sind als eine Dicke der inneren Sperrschicht in den jeweiligen Einheitszellen.

4. Halbleiterlaser nach Anspruch 3, wobei die äußeren Sperrschichten, die innere Sperrschicht und die Topfschichten in den jeweiligen Einheitszellen Dicken von jeweils 10 nm, 2 nm und 4 nm aufweisen.

5. Halbleiterlaser nach Anspruch 3, wobei die Topfschichten aus InGaAs und die innere Sperrschicht und die äußeren Sperrschichten aus AllnAs gebildet sind.

6. Halbleiterlaser nach Anspruch 3, wobei die Quantentopfstruktur ferner ein Relaxationsenergieniveau (E1) aufweist, das niedriger als das niedrigere Energieniveau, aber gleich oder höher als das Energieniveau der Ladungsträger im Kollektorbereich ist.

7. Halbleiterlaser nach Anspruch 6, wobei das höhere Energieniveau und das niedrigere Energieniveau eine Differenz aufweisen, die größer als die Differenz zwischen dem niedrigeren Energieniveau und dem Relaxationsenergieniveau ist.

8. Halbleiterlaser nach Anspruch 2, wobei die äußeren Sperrschichten mit Verunreinigungen dotiert sind, die den ersten Leitfähigkeitstyp aufweisen.

9. Halbleiterlaser nach Anspruch 1,
der ferner eine untere Mantelschicht (29) und eine obere Mantelschicht (27) aufweist, die den aktiven Bereich zwischen sich einschließen;
wobei die untere Mantelschicht, der aktive Bereich und die obere Mantelschicht eine Mesa (MS) bilden, die zwischen dem Emitterbereich und dem Kollektorbereich auf dem Substrat angeordnet ist, wobei der Emitterbereich mit einer Seite der Mesa in Kontakt steht und der Kollektorbereich mit einer anderen Seite der Mesa in Kontakt steht,
wobei die obere Mantelschicht und die untere Mantelschicht die von dem Emitterbereich stammenden und dem Kollektorbereich zugeführten Ladungsträger innerhalb des aktiven Bereichs elektrisch begrenzen.

10. Halbleiterlaser nach Anspruch 9, wobei die untere Mantelschicht und die obere Mantelschicht Licht optisch innerhalb des aktiven Bereichs eingrenzen, in dem das Licht in den Topfschichten durch den Strahlungsübergang der Ladungsträger erzeugt wird.

11. Halbleiterlaser nach Anspruch 9, wobei der Emitterbereich eine erste Halbleiterschicht (33a) und eine zweite Halbleiterschicht (33b) enthält, wobei die erste Halbleiterschicht in direktem Kontakt mit der Seite der Mesa und einer Oberseite des Substrats steht, und die zweite Halbleiterschicht auf der ersten Halbleiterschicht vorgesehen ist.

12. Halbleiterlaser nach Anspruch 9, wobei der Emitterbereich eine erste Elektrode (31a) und der Kollektorbereich eine zweite Elektrode (31b) aufweisen, wobei die Ladungsträger von der ersten Elektrode durch den Emitterbereich in den aktiven Bereich injiziert und durch den Kollektorbereich zu der zweiten Elektrode extrahiert werden.

13. Halbleiterlaser nach Anspruch 12, wobei der Kollektorbereich eine dritte Halbleiterschicht (35a) und eine vierte Halbleiterschicht (35b) aufweist, wobei der dritte Halbleiter in direktem Kontakt mit der anderen Seite der Mesa steht.

14. Halbleiterlaser nach Anspruch 11,
der ferner einen Isolierbereich (37) zwischen dem Substrat und dem Emitterbereich und zwischen dem Substrat und der Mesa aufweist, wobei der Isolierbereich den Emitterbereich und die Mesa von dem Substrat elektrisch isoliert,
wobei der Emitterbereich eine erste Elektrode aufweist, und
wobei das Substrat aus elektrisch leitfähigem Material gebildet ist und eine zweite Elektrode an einer Rückfläche (13e) des Substrats vorgesehen ist.

15. Halbleiterlaser (12, 12d), umfassend:
ein Substrat (13);
einen aktiven Bereich (15), der auf dem Substrat vorgesehen ist, wobei der aktive Bereich eine Quantentopfstruktur (21) enthält;
einen Emitterbereich (17), der auf dem Substrat vorgesehen ist, wobei der Emitterbereich einen ersten Leitfähigkeitstyp aufweist; und
einen auf dem Substrat vorgesehene Kollektorbereich (20); und
eine untere Mantelschicht (29) und eine obere Mantelschicht (27, 28), die den aktiven Bereich zwischen sich einschließen;
wobei die untere Mantelschicht, der aktive Bereich und die obere Mantelschicht eine Mesa (MS) bilden, die zwischen dem Emitterbereich und dem Kollektorbereich auf dem Substrat angeordnet ist, wobei der Emitterbereich mit einer Seite der Mesa in Kontakt steht und der Kollektorbereich mit einer anderen Seite der Mesa in Kontakt steht,
wobei die obere Mantelschicht und die untere Mantelschicht die vom Emitterbereich stammenden und dem Kollektorbereich zugeführten Ladungsträger innerhalb des aktiven Bereichs elektrisch begrenzen,
wobei die Quantentopfstruktur einen Strahlungsübergang von Ladungsträgern mit dem ersten Leitfähigkeitstyp zwischen einem höheren Energieniveau (E3) zu einem niedrigeren Energieniveau (E2) bewirkt, wobei das höhere Energieniveau niedriger als oder gleich einem Energieniveau (E17) der Ladungsträger im Emitterbereich ist,
wobei der Emitterbereich eine erste Elektrode (31a) und der Kollektorbereich eine zweite Elektrode (36) aufweisen, wobei die Ladungsträger von der ersten Elektrode durch den Emitterbereich in den aktiven Bereich injiziert und durch den Kollektorbereich zu der zweiten Elektrode extrahiert werden, und
wobei die zweite Elektrode im Kollektorbereich in direktem Kontakt mit der anderen Seite der Mesa steht, ohne dass irgendein Halbleitermaterial dazwischen angeordnet ist,
**dadurch gekennzeichnet, dass**
der aktive Bereich, der Emitterbereich und der Kollektorbereich seitlich auf einer Oberseite (13a) des Substrats angeordnet sind, so dass der Emitterbereich und der Kollektorbereich den aktiven Bereich zwischen sich einschließen.

16. Halbleiterlaser nach Anspruch 15,
wobei die obere Mantelschicht (28) einen ersten Abschnitt (28a) und einen zweiten Abschnitt (28b) aufweist, wobei der erste Abschnitt in direktem Kontakt mit dem Emitterbereich und der zweite Abschnitt in direktem Kontakt mit der zweiten Elektrode im Kollektorbereich steht, und
wobei der erste Abschnitt eine Dicke aufweist, die größer ist als die Dicke des zweiten Abschnitts.

17. Halbleiterlaser nach Anspruch 15,
wobei der Emitterbereich eine erste Halbleiterschicht (33a) und eine zweite Halbleiterschicht (33b) aufweist, wobei die erste Halbleiterschicht in direktem Kontakt mit der Mesa und dem Substrat steht, die zweite Halbleiterschicht auf der ersten Halbleiterschicht vorgesehen ist und die erste Elektrode auf der zweiten Halbleiterschicht vorgesehen ist.

## Revendications

1. Laser à semi-conducteur (11), comprenant :
un substrat (13) ;
une zone active (15) agencée sur le substrat, la zone active comprenant une structure de puits quantique (21) ;
une zone d'émetteur (17) agencée sur le substrat, la zone d'émetteur ayant un premier type de conduction ; et
une zone de collecteur (19) agencée sur le substrat, la zone de collecteur ayant le premier type de conduction, dans lequel la structure de puits quantique provoque une transition radiative de porteur du premier type de conduction d'un niveau d'énergie supérieur (E3) en un niveau d'énergie inférieur (E2), le niveau d'énergie supérieur étant inférieur ou égal à un niveau d'énergie (E17) des porteurs dans la zone d'émetteur, le niveau d'énergie inférieur étant supérieur ou égal à un niveau d'énergie (E19) des porteurs dans la zone de collecteur
**caractérisé en ce que**
la zone active, la zone d'émetteur et la zone de collecteur sont disposées latéralement sur une surface supérieure (13a) du substrat de telle sorte que la zone d'émetteur et la zone de collecteur enserrent la zone active entre elles.

2. Laser à semi-conducteur selon la revendication 1,
dans lequel la structure de puits quantique comprend au moins une cellule unitaire (15a) comprenant deux couches de puits (21a, 21b), une couche barrière extérieure (21c), et une couche barrière intérieure (21d), la couche barrière intérieure étant disposée entre les couches de puits, les couches de puits étant disposées entre la couche barrière intérieure et la couche barrière extérieure,
dans lequel les couches de puits, les couches barrières extérieures, et la couche barrière intérieure sont empilées sur le substrat.

3. Laser à semi-conducteur selon la revendication 2,
dans lequel la structure de puits quantique comprend une pluralité de cellules unitaires empilées chacune séquentiellement sur le substrat, et
dans lequel les couches barrières extérieures dans les cellules unitaires respectives ont des épaisseurs supérieures à une épaisseur de la couche barrière intérieure dans les cellules unitaires respectives.

4. Laser à semi-conducteur selon la revendication 3, dans lequel les couches barrières extérieures, la couche barrière intérieure, et les couches de puits dans les cellules unitaires respectives ont des épaisseurs de 10 nm, 2 nm, et 4 nm, respectivement.

5. Laser à semi-conducteur selon la revendication 3, dans lequel les couches de puits sont constituées d'InGaAs, et la couche barrière intérieure et les couches barrières extérieures sont constituées d'AlInAs.

6. Laser à semi-conducteur selon la revendication 3, dans lequel la structure de puits quantique fournit en outre un niveau d'énergie de relaxation (E1) inférieur au niveau d'énergie inférieur mais égal ou supérieur au niveau d'énergie des porteurs dans la zone de collecteur.

7. Laser à semi-conducteur selon la revendication 6, dans lequel le niveau d'énergie supérieur et le niveau d'énergie inférieur ont une différence supérieure à une différence entre le niveau d'énergie inférieur et le niveau d'énergie de relaxation.

8. Laser à semi-conducteur selon la revendication 2, dans lequel les couches barrières extérieures sont dopées en impuretés présentant le premier type de conduction.

9. Laser à semi-conducteur selon la revendication 1,
comprenant en outre une couche de revêtement inférieure (29) et une couche de revêtement supérieure (27) enserrant la zone active entre elles ;
dans lequel la couche de revêtement inférieure, la zone active, et la couche de revêtement supérieure forment une structure mesa (MS) disposée entre la zone d'émetteur et la zone de collecteur sur le substrat, la zone d'émetteur étant en contact avec un côté de la structure mesa, la zone de collecteur étant en contact avec un autre côté de la structure mesa,
dans lequel la couche de revêtement supérieure et la couche de revêtement inférieure confinent électriquement les porteurs provenant de la zone d'émetteur et sortant vers la zone de collecteur dans la zone active.

10. Laser à semi-conducteur selon la revendication 9, dans lequel la couche de revêtement inférieure et la couche de revêtement supérieure confinent optiquement une lumière à l'intérieur de la zone active, où la lumière est générée dans les couches de puits par la transition radiative des porteurs.

11. Laser à semi-conducteur selon la revendication 9, dans lequel la zone d'émetteur comprend une première couche semi-conductrice (33a) et une deuxième couche semi-conductrice (33b), la première couche semi-conductrice étant directement en contact avec le côté de la structure mesa et une surface supérieure du substrat, la deuxième couche semi-conductrice étant disposée sur la première couche semi-conductrice.

12. Laser à semi-conducteur selon la revendication 9, dans lequel la zone d'émetteur fournit une première électrode (31a) et la zone de collecteur fournit une seconde électrode (31b), les porteurs étant injectés dans la zone active depuis la première électrode à travers la zone d'émetteur et extraits vers la seconde électrode à travers la zone de collecteur.

13. Laser à semi-conducteur selon la revendication 12, dans lequel la zone de collecteur fournit une troisième couche semi-conductrice (35a) et une quatrième couche semi-conductrice (35b), le troisième semi-conducteur étant directement en contact avec l'autre côté de la structure mesa.

14. Laser à semi-conducteur selon la revendication 11,
comprenant en outre une zone d'isolation (37) entre le substrat et la zone d'émetteur, et entre le substrat et la structure mesa, la zone d'isolation isolant électriquement la zone d'émetteur et la structure mesa vis-à-vis du substrat,
dans lequel la zone d'émetteur fournit une première électrode, et
dans lequel le substrat est constitué d'un matériau électriquement conducteur, et une seconde électrode est disposée dans une surface arrière (13e) du substrat.

15. Laser à semi-conducteur (12, 12d), comprenant :
un substrat (13) ;
une zone active (15) agencée sur le substrat, la zone active comprenant une structure de puits quantique (21) ;
une zone d'émetteur (17) agencée sur le substrat, la zone d'émetteur ayant un premier type de conduction ; et
une zone de collecteur (20) agencée sur le substrat ; et
une couche de revêtement inférieure (29) et une couche de revêtement supérieure (27, 28) enserrant la zone active entre elles ;
dans lequel la couche de revêtement inférieure, la zone active, et la couche de revêtement supérieure forment une structure mesa (MS) disposée entre la zone d'émetteur et la zone de collecteur sur le substrat, la zone d'émetteur étant en contact avec un côté de la structure mesa, la zone de collecteur étant en contact avec un autre côté de la structure mesa,
dans lequel la couche de revêtement supérieure et la couche de revêtement inférieure confinent électriquement les porteurs provenant de la zone d'émetteur et sortant vers la zone de collecteur dans la zone active,
dans lequel la structure de puits quantique provoque une transition radiative de porteur du premier type de conduction d'un niveau d'énergie supérieur (E3) en un niveau d'énergie inférieur (E2), le niveau d'énergie supérieur étant inférieur ou égal à un niveau d'énergie (E17) des porteurs dans la zone d'émetteur,
dans lequel la zone d'émetteur fournit une première électrode (31a) et la zone de collecteur fournit une seconde électrode (36), les porteurs étant injectés dans la zone active depuis la première électrode à travers la zone d'émetteur et extraits vers la seconde électrode à travers la zone de collecteur, et
dans lequel la seconde électrode dans la zone de collecteur est directement en contact avec l'autre côté de la structure mesa sans interposition de quelconques matériaux semi-conducteurs,
**caractérisé en ce que**
la zone active, la zone d'émetteur et la zone de collecteur sont disposées latéralement sur une surface supérieure (13a) du substrat de telle sorte que la zone d'émetteur et la zone de collecteur enserrent la zone active entre elles.

16. Laser à semi-conducteur selon la revendication 15,
dans lequel la couche de revêtement supérieure (28) fournit une première partie (28a) et une seconde partie (28b), la première partie étant directement en contact avec la zone d'émetteur et la seconde partie étant directement en contact avec la seconde électrode dans la zone de collecteur, et
dans lequel la première partie a une épaisseur supérieure à une épaisseur de la seconde partie.

17. Laser à semi-conducteur selon la revendication 15,
dans lequel la zone d'émetteur comprend une première couche semi-conductrice (33a) et une deuxième couche semi-conductrice (33b), la première couche semi-conductrice étant en contact direct avec le structure mesa et le substrat, la deuxième couche semi-conductrice étant agencée sur la première couche semi-conductrice, la première électrode étant agencée sur la deuxième couche semi-conductrice.
